# EUROPEAN PATENT APPLICATION

(11) **EP 1 860 448 A2**
(43) Date of publication of application: **28.11.2007**
(21) Application number: 07106159.2
(22) Date of filing: 13.04.2007
(51) Int. Cl.: G01R 31/28

(54) **Handler for sorting packaged chips**

(30) Priority: 12.05.2006 KR 20060042996
(71) Applicant: Mirae Corporation, 330-220 Chungcheongnam-do (KR)
(72) Inventor: Kim, Jong Tae, Gwanpyeong-dong, Yuseong-gu, Daejeon-si (KR)
(74) Representative: Vetter, Ewald Otto

(57) **Abstract**

Provided is a handler for sorting packaged chips, including a main body (1), a loading unit (3) which is provided on one side of the main body (1), and where a tray containing packaged chips subject to a burn-in test waits, a burn-in board (B) containing burn-in tested packaged chips, movable working space of the main body (1), an unloading unit where a tray bound to contain burn-in tested packaged chips from a burn-in board (B) waits, a sorting unit containing bad packaged chips picked up from the burin-in board (B); and a tray-transferring unit removing packaged chips remaining in a tray from the tray while transferring the tray from the loading unit to the unloading unit. The present invention provides an advantage of turning a tray upside down during transfer of the tray from the loading unit to the unloading unit to remove packaged chips remaining in the tray for the tray.

## Description

### BACKGROUND OF THE INVENTION

### 1. Field of the Invention

The present invention relates to a handler for sorting burin-in tested packaged chips and more particularly to a handler for sorting burn-in tested packaged chips, equipped with a tray-transferring unit transferring a tray bound to contain burn-in tested packaged chips from a loading unit to an unloading unit.

### 2. Description of the Background Art

Subsequent to wafer fabrication process, a series of tests of packaged chips is performed to verify that it performs to specifications. The electrical test checks the general performance of the packaged chip and ensure that it meets certain input and output voltage, capacitance, and current specifications. The functional test actually exercises the specific chip functioning. The burn-in test is intended to stress the electrical interconnection of the chip and package and drives any contaminants in the body of the chip into the active circuitry, thus causing failure. The early failures are detected by conducting the burn-in test. The packaged chips passing the burn-in test are statistically more reliable.

The burn-in test requires the insertion of packaged chips in rows and columns in a burn-in board and mounting in a chamber with temperature-cycling capability. During the burn-in test, the circuits are temperature cycled while under an electrical bias. The package chips, after receiving the burn-in test, are sorted into good ones and bad ones by a handler for sorting burn-in tested packaged chips..

The handler, when receiving the burn-in board containing burn-in tested packaged chips, picks up the burn-in tested packaged chips from the burn-in board, sorts the burn-in tested chips into good ones and bad ones, and places new packaged chips subject to the burn-in test into the empty burn-in board.

The handler includes a main body, a loading unit which is provided on one side of the main body, and where a tray containing packaged chips subject to a burn-in test waits, a burn-in board containing burn-in tested packaged chips, movable to the main body, and an unloading unit where a tray bound to contain good packaged chips passing the burn-in test waits. The handler may further include a sorting unit containing good or bad packaged chips passing or failing the burn-in test.

The handler transfers burn-in tested packaged chips from a burn-in board to an empty tray waiting in the unloading unit, and at the same time packaged chips subject to the burin-in test, from a tray waiting in the loading unit to the burn-in board from which the burn-in tested packaged chips are removed.

At this point, the tray waiting in the loading unit, from which the packaged chips are removed, is transferred to the unloading unit and put to another use. Good packaged chips passing the burn-in test are contained in the tray transferred to the unloading unit.

However, all packaged chips are always not removed from the tray to be transferred to the unloading unit. In that case, packaged chips remain in the tray. Consequently, packaged chips from the burn-in board are placed on the packaged chips remaining in the tray transferred from the loading unit.

### BRIEF DESCRIPTION OF THE INVENTION

Therefore, an object of the present invention is to a handler for sorting burin-in tested packaged chips with a tray-transferring unit transferring a tray from a loading unit where a tray containing packaged chips subject to the burn-in test waits, to an unloading unit where a tray bound to contain burn-in tested packaged chips waits.

According to an aspect of the present invention, there is provided a handler for sorting burn-in tested packaged chips, including a main body, a burn-in board containing burn-in tested packaged chips, movable to the main body, a loading unit which is provided on one side of the main body, and where a tray containing packaged chips subject to a burn-in test waits, an unloading unit where a tray bound to contain burn-in tested packaged chips from a burn-in board waits, and a tray-transferring unit transferring a tray from the loading unit to the unloading unit.

The tray-transferring unit may include a holding unit holding and releasing the tray, a rotating unit rotating the tray and a coupling unit coupling the holding unit and the rotating unit.

The tray-transferring unit 100 may further a base frame which is provided to be movable over the main body in such a manner that transfers the tray from the loading unit to the unloading unit.

The holding unit may include a holding member holding the tray and a first driving unit for moving the holding member.

The first driving unit may include a piston rod which connects to the holding member and moves together with the holding member and an air pressure cylinder moving the piston rod.

The rotating unit may include a rotating bar rotating the holding unit and the tray and a second driving unit for rotating the rotating bar.

The holding unit and the coupling unit coupling the rotating bar and the holding unit rotate together with the rotating bar, when the rotating bar rotates.

The handler may further include a bushing supporting the rotating bar, provided to both ends of the rotating bar.

According to another aspect of the present invention, there is provided a handler for sorting burn-in tested packaged chips, a main body, a burn-in board containing burn-in tested packaged chips, movable to the main body, a loading unit which is provided on one side of the main body, and where a tray containing packaged chips subject to a burn-in test waits, an unloading unit where a tray bound to contain burn-in tested packaged chips from a burn-in board waits, and a tray-transferring unit transferring a tray from the loading unit to the unloading unit and removing packaged chips remaining in the tray, from the tray, using weight of the remaining packaged chips themselves.

According to a further aspect of the present invention, there is provided a handler for sorting burn-in tested packaged chips, a main body, a tray-transferring unit movable from one side of the main body to the other side of the main body, the tray-transferring unit including a base frame provided over the main body, movable from one side of the main body to the other side of the main body, a rotation bar provided rotatably to the base frame, a holding unit holding and releasing a try, coupled to the rotation bar, and a rotating unit rotating the rotation bar.

The tray, held on the holding unit, rotates when the rotation bar rotates the holding unit. This results in removing the remaining packaged chips from the tray.

The foregoing and other objects, features, aspects and advantages of the present invention will become more apparent from the following detailed description of the present invention when taken in conjunction with the accompanying drawings.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a view schematically illustrating a handler for sorting burn-in tested packaged chips, according to an embodiment of the present invention;
FIG. 2 is a perspective view illustrating a tray-transferring unit cut out form the handler sorting burn-in tested packaged chips as shown in FIG.1;
FIG. 3 is a plane view illustrating the tray-transferring unit of FIG.2; and
FIG. 4 is a lateral view illustrating the tray-transferring unit of FIG.2.

### DETAILED DESCRIPTION OF THE INVENTION

Reference will now be made in detail to the preferred embodiments of the present invention, examples of which are illustrated in the accompanying drawings.

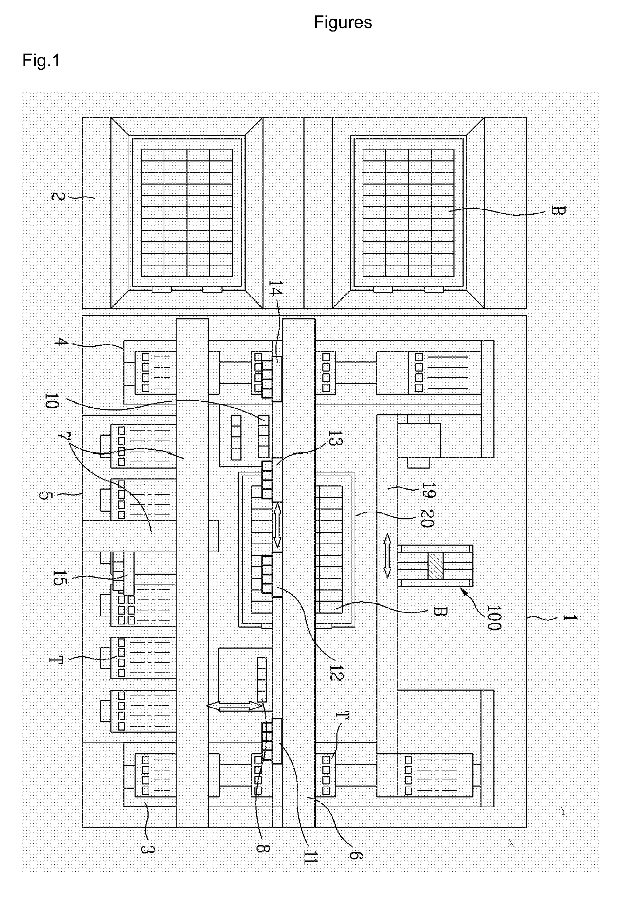

FIG. 1 is a view schematically illustrating a handler for sorting burn-in-tested packaged chips, according to an embodiment of the present invention. Referring to FIG.1, the handler for sorting burn-in-tested packaged chips is now described.

The handler for sorting burn-in-tested packaged chips includes a main body 1, a burn-in board 'B' containing burn-in-tested packaged chips, movable to the main body 1, a loading unit 3 where a tray containing packaged chips subject to a burn-in-test waits, an unloading unit 4 where a tray bound to contain good packaged chips passing the burn-in test waits.

A burn-in board transferring unit 20 moves the burn-in board 'B' to the center of the main body 1, i.e., working space. The loading unit 3 and the unloading unit 4 are provided to one side and the other side of the main body, respectively, with the burn-in board 'B' in between. A sorting unit 5, where a tray bound to contain bad packaged chips (including packaged chips again subject to the burn-in test) failing the burn-in test, is provided between the loading unit 3 and the unloading 4

The tray-transferring unit 100 is provided to transfer the tray from the loading unit 3 and the unloading unit 4. The tray-transferring unit 100 may be provided to one side of the main body, to be opposite to the sorting unit 5, with the burn-in board between the tray transferring unit 100 and the sorting unit 5.

A rack 2, where one or more burn-in board are placed, is provided adjacent to one side of the main body 1. The rack 2 includes a rack where a burn-in board is placed which contains burn-in tested packaged chips and a rack where a burn-in board is placed with contains packaged chips subject to the burn-in test.

The burn-in board transferring unit 20, which transfers the burn-in board from the rack 2 to the working space, is provided to the main body 1. The burn-in board transferring unit 20 transfers the burn-in board 'B' from the rack 2 to the main body 1 or from the main body 1 to the rack 2. The tray- transferring unit 20 may transfer the burn-in board 'B' step by step in the 'X' or 'Y' direction in the sphere of the main body 1. Otherwise, the tray transferring unit 20 may rotate the burn-in board 'B' in the Θ direction in the sphere of the main body 1. So, the tray transferring unit 20 is also referred to as an X-Y-Θ table.

A DC test unit 8, which performs an electrical test on packaged chips, is provided adjacent to one side of the loading unit 3. An unloading buffer 10, which temporarily contains burn-in tested packaged chips, is provided adjacent to one side of the unloading unit 4. The DC test unit 8 may be provided between the loading unit 6 and the working space.

This makes it possible to form the working space between the DC test unit 8 and the unloading buffer 10.

An X-axis frame 6, which extends across the DC test unit 8, the burn-in board 'B', and the unloading buffer 10, is provided over the main body 1. A loading picker 11, an inserting picker 12, a removing picker 13, and an unloading picker are provided to the X-axis frame 6.

The loading picker 11 transfers packaged chips subject to the burn-in test from the loading unit 3 to the DC test unit 8. The inserting picker 12 inserts the packaged chip in the DC test unit 8 into the burn-in board 'B'. The removing picker 13 picks up and transfers the packaged chips in the burn-in board to the unloading buffer 10. The unloading picker 14 picks up and transfers the packaged chips in the unloading buffer 10 to the unloading unit 4.

The packaged chips transferred to the DC test unit 8 receive the electrical test, known as a direct current (DC) test. The inserting picker 12 and the removing picker 13 move as one body. The removing picker 13 picks up packaged chips from the burn-in board and the inserting picker 12 places packaged chips in the DC test unit 8 at places in the burn-in board, previously occupied by the packaged chips picked up by the removing picker 13.

A sorting picker 15, which transfers bad packaged chips in the DC test unit 8 and in the unloading buffer to the sorting unit 5, is provided to an X-Y frame 7 over the sorting unit 5. The sorting picker 15 moves along the X-Y frame 7 to any given point to release the bad packaged chips.

The tray transferring unit 100, which transfers the tray in the loading unit 3 to the unloading unit 4, is provided behind the loading unit 3 and the unloading unit 4 in such a manner that the tray transferring unit 100 is movable backwards and forwards along an X-axis tray frame 19.

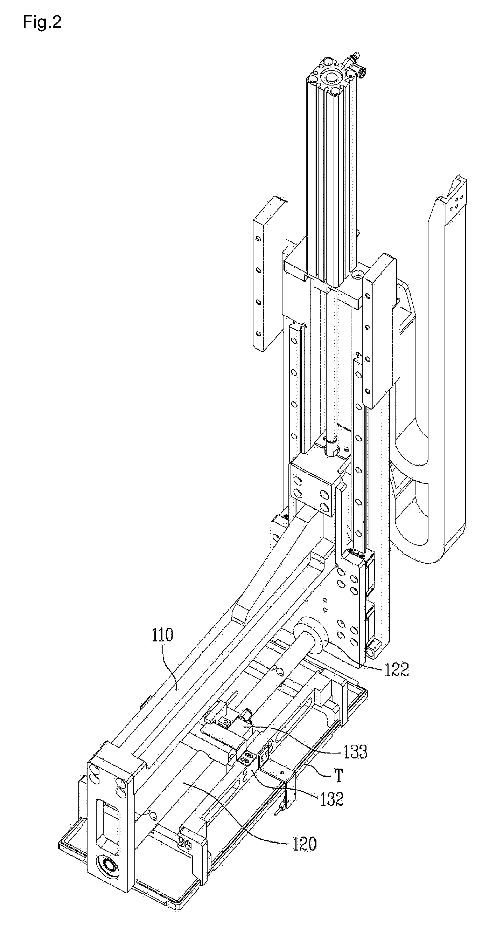

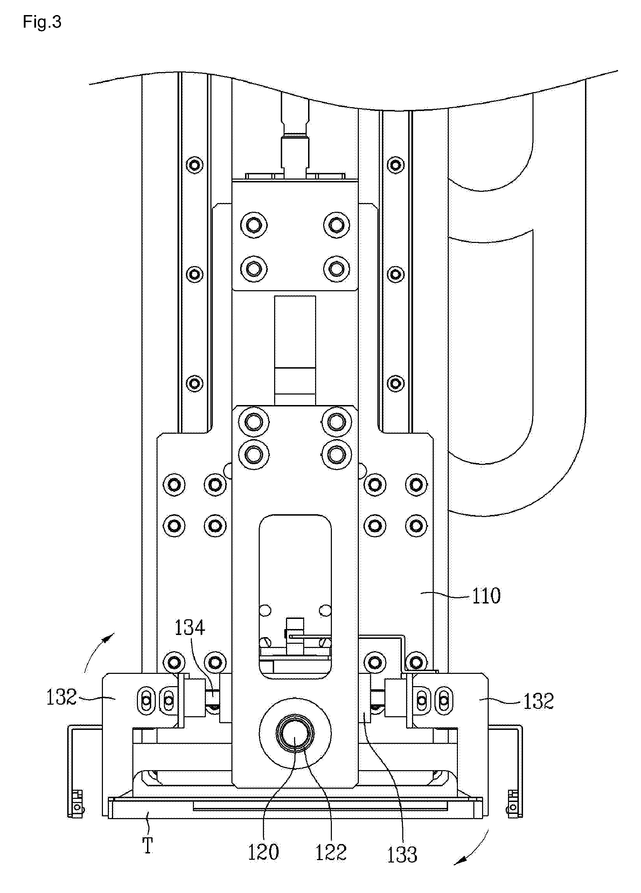

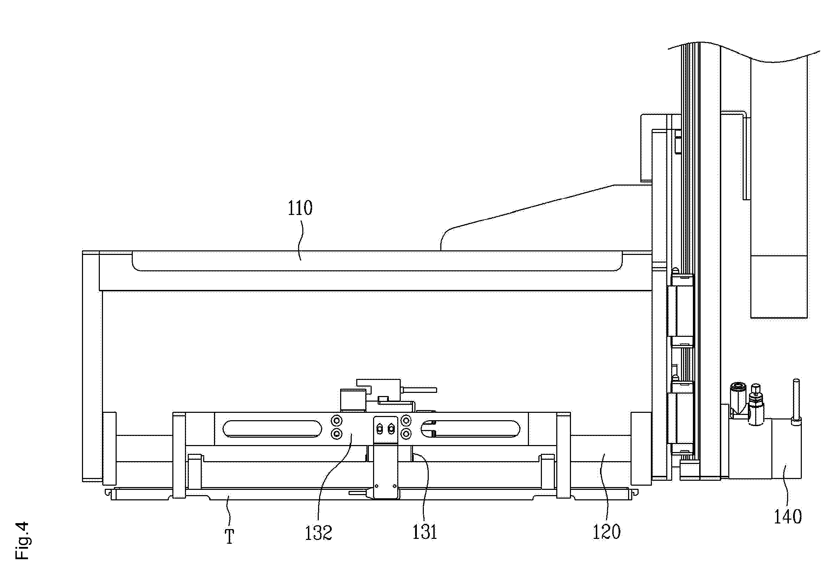

Referring FIGs 2 through 4, the tray transferring unit 100 according to the present invention is described in more detail.

The tray transferring unit 100 includes the base frame 110 movable horizontally in the X-axis direction along the X-axis tray frame 19 and vertically in the Z-axis direction, a holding unit holding and releasing the tray 'T', a rotating unit rotating the tray 'T', and a coupling unit 131 coupling the holding unit and the rotating unit.

The base frame 110 is movable horizontally in the X-axis direction along the X-axis tray frame 19 and vertically.

The holding unit includes a holding member 132 holding the tray 'T' and a first driving unit for moving the holding member 132. The first driving unit includes a piston rod 134 connected to the holding member 132 and an air pressure cylinder 133 enabling the piston rod 134 to expand and contract..

The first driving unit may include a motor and a motion-transferring member transforming rotary motion of the motor into linear motion of the holding member.

The rotating unit includes the rotating bar 120 rotating the holding unit and the tray 'T' and a second driving unit 140 for rotating the rotating bar.

The rotating bar 120 is provided to the base frame 110 which is rotatable in the 'R' direction with respect to a rotational axis of the rotating bar 120. A bushing 122 supporting the rotating bar, is provided to both ends of the rotating bar 120.

The coupling unit 131 couples the rotating bar 120 and the holding unit. Therefore, the holding unit and the coupling unit 131 rotate together with the rotating bar, when the rotating bar 120 rotates.

More specifically, one side of the coupling unit 131 connects to the middle of the rotating bar 120 and the other side to the air pressure cylinder 133 of the holding unit. A pair of piston rods 134, expandable and contractible in the both directions, connects to the air pressure cylinder 133. The pair of piston rods 134 connect to the holding member 132 holding and releasing two sides of the tray 'T'.

Piston rods 134 expand and contract, depending upon application of air pressure to the air pressure cylinder. This enables the holding member 132 connected to the pair of piston rods 134 to expand and contract. Thus, the holding member holds or releases the two sides of the tray 'T'

The second driving unit 140, which rotates the rotating bar 120 in one direction or in the opposite direction, is provided behind the base frame 110. The second driving unit 140 may include a rotary motion apparatus, such as a rotary cylinder, which connects to one end of the rotation bar 120 and thus rotates the rotation bar 120 in a given range of angle in one direction and in the opposite direction using an air pressure.

The second driving unit 140 may include a motor connecting to one end of the rotation bar 120 and thus rotating the rotation bar 120. The second driving unit 140 may include a variety of rotary motion apparatus.

Referring to FIGs 1 through 4, the handler for sorting burn-in tested packaged chips and the tray transferring unit 100 according to the present invention are now described.

The burn-in board 'B' containing burn-in tested packaged chips are drawn from the rack 2 and transferred to the working space, i.e., the middle of the main body.

At the same time, a tray 'T' in the loading unit 3 moves under the X-axis frame 6. Then, the loading picker 11 picks up packaged chips from a tray in the loading unit 3 and transfers the packaged chips to the DC test unit 8. The DC test unit 8 performs the DC test on the packaged chips.

At this point, the loading picker 11 continue to move between the loading unit 3 and the DC test unit 8 to transfer packaged chips from the loading unit 3 to the DC test unit 8.

The inserting picker 12 moves over the DC test unit 8 and the removing picker 13 moves over the burn-in board 'B', after the DC test unit 8 performs the DC test on packaged chips. The inserting picker 12 and the removing picker 13, coupled to each other, move together.

Subsequently, the inserting picker 12 picks up packaged chips in the DC test unit 8 and moves over the burn-in board, holding the packaged chips, and the removing picker 13 picks up burn-in- tested packaged chips and moves to the unloading buffer 10, holding the burn-in tested packaged chips. That is, the removing picker 13 picks up packaged chips from the burn-in board and the inserting picker 12 places packaged chips on places previously occupied by the packaged chips picked up by the removing picker 13.

The inserting picker 12 and the removing picker 13 together repeat so-called picking-up and placing operation.

Subsequently, the unloading picker 14 picks up good packaged chips passing the burn-in test from the unloading buffer 10 and places the picked-up good packaged chips in a tray 'T'.

At this point, the sorting picker 15 moves along the X-Y axis frame 7 to pick up bad packaged chips in the unloading buffer 10 and transfer the bad packaged chips to a tray 'T' in the sorting unit 5.

The board transferring unit 20 transfers the burn-in board 'B' to the rack 2, after burn-in tested packaged chips are all picked up from a burn-in board 'B' to be divided into good one and bad ones, and new packaged chips subject to the burn-in test are placed on the places in the burn-in board 'B', previously occupied by the picked-up burn-in tested package chips,

All packaged chips contained in the tray 'T' move to the DC test unit 8 and then the tray 'T' moves behind the loading unit 3.

Subsequently, the tray transferring unit 100 holds an empty tray 'T' using the holding member 132, and transfers the empty tray 'T' to the unloading unit 4.

When the base frame 110 reach a given position while moving along the X-axis tray frame 19 to the unloading unit 4, the second driving unit 140 operates to rotate the empty tray 'T'. That is, the tray transferring unit 100 rotates the empty tray 'T' during transfer of the empty tray 'T' to completely remove packaged chips which fails to be picked up and remains in the empty tray.

For example, when the second driving unit rotates the rotation bar by 180 degrees, the coupling unit and the holding unit coupled to the rotation bar rotates together with the rotation bar, and thus a tray 'T" coupled to the holding unit 132 rotates by 180 degrees. The 180 ° Rotation of the rotation bar turns the tray 'T' upside down. Thus, the remaining packaged chips drop downwards from the try 'T'

The remaining packaged chips dropping from the tray 'T' gather in a collection box (not shown) provided under a specific position between the loading unit 3 and the unloading unit 4.

In this way, the remaining packaged chips drop from the upside-down tray 'T' due to weight of the remaining packaged chips themselves, while the tray 'T' is transferred from the loading unit 3 to the unloading unit 4.

When the tray transferring unit 100 transfers the empty tray 'T' to the unloading unit 4, the holding member 132 is spread to release the empty tray 'T'. The released empty tray 'T' reaches the unloading unit 4. Thereafter, the tray transferring unit 100 moves backwards to the loading unit 3 to transfer a next tray 'T' from the loading unit 3

The handler for sorting packaged chips according to the present invention is capable of turning a tray upside down during transfer of the tray from the loading unit to the unloading unit to remove packaged chips remaining in the tray for the tray. This prevents packaged chips from being placed on the chips remaining in the tray when the tray is put to another use..

As the present invention may be embodied in several forms without departing from the spirit or essential characteristics thereof, it should also be understood that the above-described embodiments are not limited by any of the details of the foregoing description, unless otherwise specified, but rather should be construed broadly within its spirit and scope as defined in the appended claims, and therefore all changes and modifications that fall within the metes and bounds of the claims, or equivalents of such metes and bounds are therefore intended to be embraced by the appended claims.

## Claims

**1.** A handler for sorting packaged chips, comprising:
a main body;
a loading unit which is provided on one side of the main body, and where a tray containing packaged chips subject to a burn-in test waits;
a burn-in board containing burn-in tested packaged chips, movable working space of the main body;
an unloading unit where a tray bound to contain burn-in tested packaged chips from a burn-in board waits;
a sorting unit containing bad packaged chips picked up from the burin-in board; and
a tray-transferring unit removing packaged chips remaining in a tray from the tray while transferring the tray from the loading unit to the unloading unit.

**2.** The handler for sorting packaged chips according to claim 1, wherein the tray-transferring unit comprises:
a holding unit holding and releasing the tray;
a rotating unit rotating the tray; and
a coupling unit coupling the holding unit and the rotating unit.

**3.** The handler for sorting packaged chips according to claim 2, wherein the tray-transferring unit comprises a base frame to which the holding unit holding is provided.

**4.** The handler for sorting packaged chips according to claim 2, wherein the holding unit comprises a holding member holding the tray and a first driving unit for moving the holding member.

**5.** The handler for sorting packaged chips according to claim 2, wherein the first driving unit may include a piston rod which connects to the holding member and an air pressure cylinder enabling the piston rod to expand and contract.

**6.** The handler for sorting packaged chips according to claim 3, wherein the rotating unit further comprises a rotating bar provided to be rotatable with respect to the base frame and a second driving unit for rotating the rotating bar.

**7.** The handler for sorting packaged chips according to claim 5, wherein the holding unit and the coupling unit coupling the rotating bar and the holding unit rotate together the rotating bar when the rotating bar rotates.

**8.** The handler for sorting packaged chips according to claim 6, wherein a bushing supporting the rotating bar is provided to both ends of the rotating bar.

**9.** A handler for sorting packaged chips, comprising:
a main body;
a burn-in board containing burn-in tested packaged chips, movable to the main body;
a loading unit loading packaged chips subject to a test onto the burn-in board;
an unloading unit where a tray bound to contain tested packaged chips from the burn-in board waits; and
a tray-transferring unit transferring a tray from the loading unit to the unloading unit and removing packaged chips remaining in the tray, from the tray, using weight of the remaining packaged chips themselves.

**10.** A handler for sorting packaged chips according to claim 9, wherein the tray-transferring unit comprises:
a base frame to which a holding unit is provided;
the holding unit holding and releasing the tray;
a rotating unit provided to be rotatable with respect to the base frame, rotating the tray; and
a coupling unit coupling the holding unit and the rotating unit.

**11.** A tray-transferring unit provided to a handler for sorting packaged chips comprising a main body, a burn-in board containing burn-in tested packaged chips, movable to the main body, a loading unit which is provided on one side of the main body and where a tray containing packaged chips subject to a test waits, and an unloading unit where a tray bound to contain tested packaged chips from the burn-in board waits, the tray-transferring unit removes packaged chips remaining in a tray by rotating the tray while transferring the tray from the loading unit to the unloading unit.

**12.** The tray-transferring unit according to claim 11, comprising:
a base frame to which a holding unit is provided;
the holding unit holding and releasing the tray;
a rotating unit provided to be rotatable with respect to the base frame, rotating the tray; and
a coupling unit coupling the holding unit and the rotating unit.
